# EUROPEAN PATENT APPLICATION

(11) **EP 4 354 507 A1**
(43) Date of publication of application: **17.04.2024**
(21) Application number: 22824290.5
(22) Date of filing: 16.06.2022
(51) Int. Cl.: H01L 27/32, H01L 51/52

(54) **DISPLAY APPARATUS AND ELECTRONIC DEVICE**

(30) Priority: 18.06.2021 CN 202110683435
(71) Applicant: Huawei Technologies Co., Ltd., Shenzhen, Guangdong 518129 (CN)
(72) Inventor: ZHU, Ming, Shenzhen, Guangdong 518129 (CN); NI, Huan, Shenzhen, Guangdong 518129 (CN)
(74) Representative: Epping - Hermann - Fischer
(86) International application number: PCT/CN2022/099212
(87) International publication number: WO 2022/262817

(57) **Abstract**

This application provides a display apparatus and an electronic device. The display apparatus includes: a substrate; a light emitting layer, disposed on the substrate, where the light emitting layer includes a plurality of subpixels; and a light converging layer, disposed on a side that is of the light emitting layer and that is away from the substrate, where the light converging layer includes a plurality of light converging structures, the plurality of light converging structures cover the plurality of subpixels, and the light converging structures are configured to converge light emitted by the subpixels covered by the light converging structures. In this application, the light converging structures are disposed in the display apparatus to converge light, so that more light can be extracted outside of the display apparatus, to improve output efficiency of light of the display apparatus.

## Description

This application claims priority to Chinese Patent Application No. 202110683435.0, filed with the China National Intellectual Property Administration on June 18, 2021 and entitled "DISPLAY APPARATUS AND ELECTRONIC DEVICE", which is incorporated herein by reference in its entirety.

### TECHNICAL FIELD

This application relates to the field of display device technologies, and more specifically, to a display apparatus and an electronic device.

### BACKGROUND

An organic light emitting diode (organic light emitting diode, OLED) display device has many advantages such as self-illumination, rich color, fast response speed, wide viewing angle, light weight, thin thickness, low power consumption, flexible display, and the like, and therefore is generally recognized as the most potential display apparatus in the industry. To implement an outdoor visibility function of an OLED panel, a circular polarizer (circular polarizer, C POL) may be disposed on a light output side of the OLED panel. The circular polarizer can effectively reduce a reflective index of the panel under strong light, so that a contrast ratio of the OLED panel is greatly improved. However, the circular polarizer is an absorptive polarizer, and light transmittance is about 43%. Therefore, about 60% of light emitted by the OLED panel is absorbed, and output efficiency of light of the OLED panel is reduced.

To resolve the foregoing problem, a color filter on thin film encapsulation (color filter on thin film encapsulation, COE) technology is proposed in the industry. The COE is a new technology that can replace a polarizer, where a color filter (color filter, CF) is fabricated on a thin film encapsulation (thin film encapsulation, TFE) layer, so that a reflective index of the OLED panel can be lowered to a level comparable to that of the circular polarizer. In addition, the output efficiency of light of the OLED panel can be improved to about 60%.

With development of economy and progress of science and technology, a use requirement of a user for an electronic device is accordingly increasing. Although the output efficiency of light of the OLED panel using the COE architecture is improved to an extent, the output efficiency of light still cannot meet the use requirement of the user. Currently, to achieve higher luminance, more power consumption needs to be provided for the OLED panel, and therefore a service life of the OLED panel is reduced. Therefore, providing an OLED panel with higher output efficiency of light becomes an urgent problem to be resolved.

### SUMMARY

This application provides a display apparatus and an electronic device. Alight converging structure is disposed in the display apparatus to converge light, so that more light can be extracted outside of the display apparatus, to improve output efficiency of light of the display apparatus. According to a first aspect, a display apparatus is provided, including a substrate; a light emitting layer, disposed on the substrate, where the light emitting layer includes a plurality of subpixels; and a light converging layer, disposed on a side that is of the light emitting layer and that is away from the substrate, where the light converging layer includes a plurality of light converging structures, the plurality of light converging structures cover the plurality of subpixels, and the light converging structures are configured to converge light emitted by the subpixels covered by the light converging structures.

The light emitted by the subpixel can be emitted to an outer surface of the display apparatus through the light converging structure. The outer surface is an interface between the display apparatus and an external environment, and is also an interface that is between an optically denser medium and an optically thinner medium and where total reflection is easy to occur. Under a refraction action of the light converging structure, a part of the light emitted by at least one subpixel can be converged in a direction of a normal line (an inner side of an orthographic projection) of the light converging structure as a whole, so that an incident angle of this part of the light entering the outer surface of the display apparatus is reduced. Therefore, the incident angle of this part of the light is less than a critical value of a total reflection phenomenon, so that the total reflection phenomenon of the light in the display apparatus is reduced or completely avoided, and more light can pass through the outer surface of the display apparatus and enter the environment. As a result, the output efficiency of light of the display apparatus is improved.

According to the display apparatus provided in this embodiment of this application, the light converging layers including an array of light converging structures are disposed in the display apparatus, to converge the light emitted by the subpixels of the light emitting layer. Each light converging structure converges (gathers) light emitted by a corresponding subpixel of the light converging structure, so that light of a part of a large viewing angle is transferred to a small viewing angle, and light that should be completely reflected and dissipated in the display apparatus is extracted to the outside of the display apparatus. As a result, the output efficiency of light of the display apparatus is improved.

The display apparatus provided in this embodiment of this application has higher output efficiency of light, and can meet a use requirement of a user for a display apparatus with high luminance. Because the output efficiency of light is higher, not only power consumption of the apparatus can be reduced, but also a service life of the apparatus can be prolonged.

Optionally, to supply power to the light emitting layer, a circuit layer may be further disposed between the substrate and the light emitting layer. The circuit layer may be, for example, a thin film transistor array layer. The substrate may be made of any material such as glass, ceramic, plastic, metal, or rubber. This is not limited in this application.

In a possible implementation, the substrate may be made of a flexible material, for example, made of polyimide (polyimide, PI), so that the substrate can be bent and deformed, and the display apparatus can meet a use requirement of a foldable terminal device (for example, a foldable mobile phone).

Optionally, a material of the light converging structure may be an acrylic acid resin, a polyimide resin, a siloxane resin, a phenol-formaldehyde resin, a resin system compounded with a metal nanoparticle, or the like. This is not limited in this application.

In a possible design, the plurality of light converging structures cover the plurality of subpixels in a one-to-one correspondence. Through the foregoing setting, a light converging (gathering) effect of each subpixel can be best, and more light can be extracted to the outside of the display apparatus, so that the output efficiency of light of the display apparatus is improved.

Optionally, in another implementation, each light converging structure may also correspondingly cover a plurality of subpixels. Alternatively, a plurality of light converging structures (for example, arranged in parallel or stacked) may simultaneously cover one subpixel. All of the foregoing settings can converge light of the subpixels, and should fall within the protection scope of this application.

It should be noted that, when each light converging structure covers a plurality of subpixels, the light converging structure can simultaneously converge light emitted by the plurality of subpixels. In this case, the light converging structure converges the light emitted by the plurality of subpixels as a whole in a direction of a normal line or a center line (an inner side of an orthographic projection) of the light converging structure. That is, a reference object of convergence is relative to the light converging structure.

In a possible design, the display apparatus further includes a light filtering layer, disposed between the light emitting layer and the light converging layer, where the light filtering layer includes a plurality of color resistance units and a black matrix surrounding the color resistance units, and the plurality of color resistance units cover the plurality of subpixels in a one-to-one correspondence. In the display apparatus provided in this embodiment of this application, the light filtering layer is disposed, and a polarizer configured to prevent reflection of ambient light does not need to be disposed on a light output side of the light emitting layer. This can improve the output efficiency of light of the display apparatus, reduce power consumption of the display apparatus, and prolong the service life of the display apparatus.

Optionally, the color resistance unit may be a color filter. A red color resistance unit, a green color resistance unit, or a blue color resistance unit are respectively a red color filter, a green color filter, or a blue color filter. A thickness of the color filter may be 1 to 5 microns. The color filter can be formed by a mature process such as spin coating or inkjet printing.

Optionally, a thickness of the black matrix is 1.5 to 5 microns, a proportion of an area occupied by the black matrix in the light filtering layer is greater than 50%, for example, 75% to 85%, and the thickness of the black matrix may be the same as the thickness of the color filter.

In a possible design, a percentage of an area of the light converging structure to a light emitting area of the subpixel is 0.6 to 2.2, and the area of the light converging structure is a cross-sectional area at a height of 10% of a total height of the light converging structure.

Through the foregoing setting, it can be ensured that most (for example, more than 60% of the area) of the light emitted by the subpixel is covered by the light converging structure, so that the light converging structure can converge most of the light, and this helps improve the output efficiency of light of the apparatus.

In a possible design, the height of the light converging structure is greater than or equal to 2 microns. Thus, the light converging structure has a better light converging effect.

In a possible design, the light converging structure is a light converging microlens, such as a convex lens.

Optionally, a surface type of a convex surface of the convex lens may be any one of a spherical surface, an ellipsoidal surface, a parabolic surface, a free-form surface, or the like.

In a possible design, the display apparatus further includes a protective layer, disposed on a side that is of the light converging layer and that is away from the substrate, where a refractive index of the light converging structure is greater than a refractive index of the protective layer. The protective layer covers the light converging layer, and can isolate and protect the light converging structure.

Optionally, the protective layer is made of a material with high light transmittance, for example, may be optically clear adhesive (optically clear adhesive, OCA). The optically clear adhesive is a double-sided adhesive tape without a base material, and has a characteristic such as colorlessness and transparency, high light transmittance (total light transmittance > 99%), high adhesion, high temperature resistance, ultraviolet resistance, and the like. The optically clear adhesive has a controlled thickness, can provide uniform spacing, and long-term use does not produce yellowing, peeling and deterioration problems.

Optionally, the optically clear adhesive may be liquid optical clear adhesive (liquid optical clear adhesive, LOCA). The LOCA is a liquid glue that is colorless and transparent after curing, has a light transmittance of more than 98%, and has a characteristic such as low curing shrinkage and yellowing resistance. In the field of full lamination, compared with traditional OCA tape, LOCA has unique advantages in large size, curved surface, harsh environment and other fields. For example, the LOCA may be an optical clear resin (optical clear resin, OCR).

Optionally, the protective layer may be made of sat least one material of an acrylic resin, an epoxy resin, a phenol-formaldehyde resin, a polyurethane, a polyamide resin, a polyimide resin, an unsaturated polyester, and the like, and total light transmittance of the protective layer is greater than or equal to 99%.

In a possible design, a difference between the refractive index of the light converging structure and the refractive index of the protective layer is 0.1 to 0.5. Through the foregoing setting, the light converging structure can have a better light converging effect.

For example, the refractive index of the light converging structure ranges from 1.6 to 1.8, and the refractive index of the protective layer range from 1.4 to 1.55.

In a possible design, the display apparatus further includes a scattering layer, disposed on the side that is of the light converging layer and that is away from the substrate, where a haze value of the scattering layer is 20% to 70%, for example, the haze value is 40% to 55%.

In a COE architecture, a diffraction problem may easily occur when light that is incident inside the display apparatus is reflected. As a result, a colorful diffraction color pattern is generated under strong light (for example, under a point light source or sunlight or a lamp) in an external environment, and reading experience is seriously affected. In this application, the scattering layer is disposed on the light output side of the light emitting layer, so that a regular diffraction pattern can be dispersed, to eliminate a diffraction problem and improve reading experience of the user. In a possible design, the scattering layer is formed by scattering particles dispersed inside the protective layer.

Optionally, the scattering particles are doped in a manufacturing process of the protective layer. A size of the scattering particles is greater than 2 microns and less than half of a length of a shortest side of the subpixel. A material of the scattering particle may be an organic scattering particle such as cross-linked polystyrene (polystyrene, PS), cross-linked polymethyl methacrylate (polymethyl methacrylate, PMMA), organic silicon polymer, or may be an inorganic scattering particle such as titanium dioxide. The scattering particles need to be fully mixed in a sample preparation process to ensure that distribution uniformity of the scattering particles is greater than 85%. A method of adjusting the haze value can be achieved by controlling a percentage of matrix resin to the scattering particles.

In a possible design, the scattering particle is in a spherical structure, and a diameter of the spherical structure is 1 to 3 microns.

In a possible design, the display apparatus further includes: an encapsulation layer, disposed between the light emitting layer and the light converging layer; and a scattering layer, disposed between the encapsulation layer and the light converging layer, where a haze value of the scattering layer is 5% to 85%.

Optionally, the encapsulation layer may be a thin film encapsulation layer. The encapsulation layer is configured to encapsulate and protect the light emitting layer, to prevent impurities such as water vapor and oxygen from entering the light emitting layer and causing erosion damage to the light emitting layer.

Optionally, the encapsulation layer may be formed by one layer of thin film structure or by superimposing a plurality of layers of thin film structures. For example, the encapsulation layer may include at least one inorganic material layer and/or an organic material (such as silicon nitride or silicon oxide) layer.

In a possible design, the display apparatus further includes a touch layer, disposed between the encapsulation layer and the light converging layer, where the touch layer includes an overcoating layer, and the scattering layer is formed by scattering particles dispersed inside the overcoating layer. In this embodiment of this application, an overcoating layer of a touch layer is reused, and scattering particles are dispersed inside the overcoating layer to form the scattering layer. This helps reduce an overall thickness of a display panel.

In a possible design, the plurality of light converging structures cover a plurality of blue subpixels in a one-to-one correspondence.

In other words, the plurality of light converging structures of the light converging layer cover only the blue subpixels, and do not cover red subpixels or green subpixels. Because light emitting power consumption of the blue subpixel accounts for almost half of working power consumption of the whole display apparatus, under a premise that a quantity of light converging structures is limited, the light converging structure only covers the blue subpixel and performs light obtaining, so that the light emitting power consumption of the blue subpixel can be effectively reduced, and overall power consumption of the display apparatus is reduced to a maximum extent.

In addition, the light converging structure covers only the blue subpixel, which also helps reduce setting density of the light converging structure, and further helps reduce processing difficulty of the light converging layer in the manufacturing process.

In a possible design, the subpixel includes an organic light emitting diode or a micron light emitting diode.

In a possible design, the display apparatus further includes: a cholesteric liquid crystal layer, disposed on the side that is of the light emitting layer and that is away from the substrate, where the cholesteric liquid crystal layer is configured to reflect, to the light emitting layer, light emitted by the subpixel in a second rotation direction, and allow light in a first rotation direction to pass through, and the light emitting layer is further configured to rotate the light in the second rotation direction to the first rotation direction and reflect the light to the cholesteric liquid crystal layer; and a circular polarizer layer, disposed on a side that is of the cholesteric liquid crystal layer and that is away from the substrate, where the circular polarizer layer includes a phase retardation film and a linear polarizer, and the phase retardation film is configured to convert the light in the first rotation direction into vertical polarized light or horizontal polarized light that can pass through the linear polarizer.

According to the display apparatus provided in this embodiment of this application, the cholesteric liquid crystal layer is disposed between the light emitting layer and the circular polarizer to selectively reflect left-handed polarized light or right-handed polarized light to the light emitting layer of the display apparatus. The light emitting layer rotates and re-reflects the reflected left-handed or right-handed polarized light, so that both the left-handed polarized light and the right-handed polarized light emitted by the light emitting layer can finally be emitted to the outside of the display apparatus through the circular polarizer, to improve the output efficiency of light of the display apparatus.

Optionally, the light in the first rotation direction is the left-handed polarized light, and the light in the second rotation direction is the right-handed polarized light. In this case, the cholesteric liquid crystal layer can reflect the right-handed polarized light emitted by the subpixel of the light emitting layer back to the light emitting layer, and transparently transmit the left-handed polarized light. The light emitting layer rotates the right-handed polarized light to the left-handed polarized light, and then reflects the left-handed polarized light back to the cholesteric liquid crystal layer. Optionally, the light in the first rotation direction may be right-handed polarized light, and the light in the second rotation direction is left-handed polarized light. In this case, configuration (a helix direction) of the cholesteric liquid crystal layer can be changed, so that the cholesteric liquid crystal layer can reflect the left-handed polarized light and transparently transmit right-handed polarized light. The linear polarizer is configured to transmit vertical polarized light and shield (block) horizontal polarized light.

Optionally, the linear polarizer may be a metal wire grid polarizer, a multi-layer double refraction polymer film polarizer, or a MacNeille polarizer.

In a possible design, the cholesteric liquid crystal layer includes a plurality of liquid crystal patterns, and the plurality of cholesteric liquid crystal patterns cover the plurality of subpixels in a one-to-one correspondence.

In a possible design, an operating waveband of the cholesteric liquid crystal layer includes entire visible light.

In a possible design, the light converging layer further includes a black matrix surrounding the light converging structure. Through the foregoing setting, the black matrix can absorb ambient light emitted from the external environment, to reduce the reflective index of the panel and improve the contrast percentage of the display apparatus.

In a possible design, the plurality of light converging structures cover the plurality of blue subpixels in a one-to-one correspondence, and the operating waveband of the cholesteric liquid crystal layer includes a blue light waveband.

In a possible design, the light converging layer further includes a yellow photoresist surrounding the light converging structure. The yellow photoresist allows green light and red light to pass through, and absorbs light of another waveband. By setting the yellow photoresist, the reflective index of the display apparatus can be reduced and the contrast percentage of the display apparatus can be improved.

According to a second aspect, an embodiment of this application further provides an electronic device. The electronic device includes a housing and the display apparatus provided in any possible design of the first aspect. The display apparatus is mounted on the housing.

Optionally, the electronic device is any electronic product with a display function, and includes but is not limited to a mobile phone (like a foldable mobile phone), a tablet computer, a television, a notebook computer, a computer display, a smart watch, an in-vehicle display device, a navigator, and the like.

### BRIEF DESCRIPTION OF DRAWINGS

FIG. 1 is a schematic diagram of a working principle of a circular polarizer;
FIG. 2 is a schematic diagram of a structure of an OLED panel based on a COE architecture according to an embodiment of this application;
FIG. 3 is a schematic diagram of a principle of a total reflection phenomenon of light emitted by an OLED panel according to an embodiment of this application;
FIG. 4 is a schematic diagram of a structure of an example of a display apparatus according to an embodiment of this application;
FIG. 5 is a comparison diagram of effect simulation between a display apparatus according to an embodiment of this application and a display apparatus in the conventional technology;
FIG. 6 is a schematic diagram of a cross section of a light converging structure according to an embodiment of this application;
FIG. 7 is a schematic diagram of a structure of another example of a display apparatus according to an embodiment of this application;
FIG. 8 is a schematic diagram of a structure of a touch layer according to an embodiment of this application;
FIG. 9 is a schematic diagram of a structure of still another example of a display apparatus according to an embodiment of this application;
FIG. 10 is a schematic diagram of an operation principle of a cholesteric liquid crystal layer;
FIG. 11 is a schematic diagram of a structure of still another example of a display apparatus according to an embodiment of this application;
FIG. 12 is a schematic diagram of a structure of still another example of a display apparatus according to an embodiment of this application;
FIG. 13 is a schematic diagram of a structure of still another example of a display apparatus according to an embodiment of this application; and
FIG. 14 is a schematic diagram of a structure of an electronic device according to an embodiment of this application.

Reference numerals: 1: linear polarizer; 2: phase retardation film; 3: cathode layer of an OLED structure;
10: substrate; 20: thin film transistor array layer; 30: organic light emitting layer; 31: pixel define layer; 32: subpixel light emitting unit; 33: anode layer; 34: cathode layer; 40: thin film encapsulation layer; 50: overcoating layer; 60: color filter layer; 61: black matrix; 62: color resistance unit; 70: connection layer; 80: cover layer; 90: functional layer;
L 1: first light; L2: second light; L3: third light;
100: display apparatus; 110: substrate; 111: circuit layer; 120: light emitting layer; 121: subpixel; 122: pixel define layer; 123: anode layer; 124: cathode layer; 130: encapsulation layer; 140: overcoating layer; 150: light filtering layer; 151: color resistance unit; 152: black matrix; 160: light converging layer; 161: light converging structure; 170: protective layer; 80: cover layer; 190: functional layer;
T 1: first overcoating layer; T2: second overcoating layer; T3: buffer layer;
200: display apparatus; 210: substrate; 220: circuit layer; 230: light emitting layer; 231: subpixel; 240: encapsulation layer; 250: light converging layer; 251: light converging structure; 252: black matrix; 253: yellow photoresist; 260: cholesteric liquid crystal layer; 261: liquid crystal pattern; 270: circular polarizer; 271: phase retardation film; 272: linear polarizer; 280: connection layer; 290: cover layer;
1000: electronic device; 1100: housing; and 1200: display apparatus.

### DESCRIPTION OF EMBODIMENTS

The following describes implementations of this application in detail. Examples of the implementations are shown in the accompanying drawings. Same or similar reference signs are always used to represent same or similar elements or elements having same or similar functions. The implementations described below with reference to the accompanying drawings are examples, and are merely used to explain this application, but cannot be understood as a limitation on this application.

It should be understood that, the terms "first" and "second" in descriptions of this application are merely intended for a purpose of description, and shall not be understood as an indication or implication of relative importance or implicit indication of the number of indicated technical features. Therefore, a feature limited by "first" or "second" may explicitly or implicitly include one or more of the features. In the description of this application, "a plurality of" means two or more than two, unless otherwise specifically limited.

In the description of this application, it should be noted that, unless otherwise specified and limited, terms "installation", "connection", and "fastening" should be understood in a broad sense. For example, a connection may be a fixed connection, a detachable connection, or an integrated connection. Alternatively, a connection may be a mechanical connection or an electrical connection, or may mean mutual communication. Alternatively, a connection may be a direct connection, or an indirect connection through an intermediate medium, or may be a connection between two elements or an interaction relationship between two elements. A person of ordinary skill in the art may interpret specific meanings of the foregoing terms in this application according to specific cases.

In the description of this application, locations or location relationships indicated by terms "up", "down", "side", "in front of", "behind", "inside", "outside", and the like are based on locations or location relationships based on installation, and are merely intended for ease of describing this application and simplifying descriptions, instead of indicating or implying that a mentioned apparatus or component needs to be provided on a specific location or constructed and operated on a specific location, and therefore shall not be understood as limitations on this application.

It should be further noted that in embodiments of this application, a same reference numeral indicates a same component or a same part. For same parts in embodiments of this application, only one part or component marked with a reference numeral may be used as an example in the figure. It should be understood that the reference numeral is also applicable to another same part or component.

An organic light emitting diode (organic light emitting diode, OLED) display device has many advantages such as self-illumination, rich color, fast response speed, wide viewing angle, light weight, thin thickness, low power consumption, flexible display, large-area full color display, and the like, and is generally recognized as the most potential display apparatus in the industry. An OLED display apparatus made of an OLED display panel is regarded as a display apparatus with great application prospect. Especially in the field of over coating panel display, the OLED display apparatus is considered as a development trend.

A plurality of pixels arranged in an array are disposed in the OLED display panel, and each pixel includes a corresponding quantity of subpixels based on a color matching mode of the OLED display panel. For example, when the OLED display panel uses a red-green-blue (red-green-blue, RGB) color matching mode, each pixel may include three subpixels. One subpixel is an R subpixel, one subpixel is a G subpixel, and one subpixel is a B subpixel. Each subpixel includes a light emitting element, and a light emitting layer in the light emitting element is excited by an exciton formed after a hole and an electron are combined, and emits light of a corresponding color. In other words, the R subpixel, the G subpixel, and the B subpixel emit red, green, and blue light respectively.

In an actual application, the OLED display panel may alternatively use a red-green-blue-white (red-green-blue-white, RGBW) color matching mode. In this case, each pixel includes four subpixels. The four subpixels include an R subpixel that can display red light, a G subpixel that can display green light, a B subpixel that can display blue light, and a W subpixel that can display white light.

An OLED may be classified into a passive matrix OLED (passive matrix OLED, PMOLED) and an active matrix OLED (active matrix OLED, AMOLED) based on a driving manner. The active matrix OLED is also referred to as an active OLED. Because the AMOLED is driven by integrating a thin film transistor (thin film transistor, TFT) and a capacitor in each pixel and maintaining a voltage by the capacitor, a large-scale and high-resolution panel can be implemented, and luminous efficiency is high. This is a focus of current research and a development direction of future display technology. The OLED panel in embodiments of this application mainly relates to an AMOLED. The AMOLED generally has an anode (anode) layer, an organic light emitting layer, a cathode (cathode) layer, and the like that are sequentially formed on a substrate. In order to improve a hole implementation efficiency, the anode layer needs to be made of a material with a work function as high as possible, such as indium tin oxide (indium tin oxide, ITO). When the material of the cathode layer is selected, a lower work function indicates a lower barrier between an organic material and a cathode, easier electron injected, and higher luminous efficiency. At present, a commonly used cathode material is magnesium silver alloy.

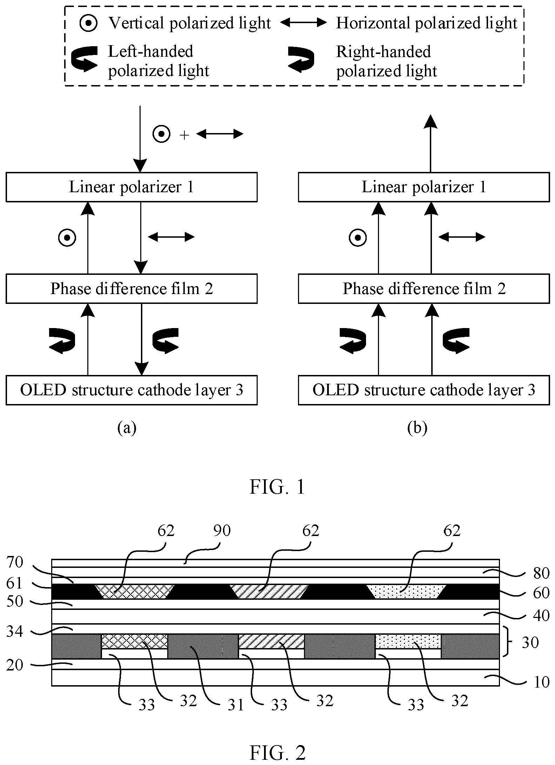

Because the cathode layer is made of a metal material, an ambient light is easy to be reflected from the outside, so that a contrast observed by a user is greatly reduced. For example, when the user views content on a screen under the sun, the user cannot clearly view the content on the screen due to reflection of the cathode layer on sunlight. To resolve this problem, a polarizer (polarizer, POL) may be attached to the outside of the AMOLED display panel, and the polarizer is a circular polarizer (circular polarizer, C POL) with a phase retardation film. The polarizer adopts a principle of polarized light, and can effectively reduce reflection intensity of ambient light on the screen. FIG. 1 is a schematic diagram of a working principle of a circular polarizer. As shown in part (a) of FIG. 1, the circular polarizer includes a linear polarizer 1 and a phase retardation film 2. After external ambient light passes through the linear polarizer 1 whose absorption axis is vertical, only half of horizontally linearly polarized light is left. After passing through the phase retardation film 2, the horizontal polarized light is converted into left-handed (circular) polarized light. After being reflected by a metal electrode of a cathode layer 3 of the OLED structure, the left-handed polarized light is rotated by 180° to become right-handed polarized light. After passing through the phase retardation film 2, the right-handed polarized light is converted into vertical polarized light. The vertical polarized light cannot pass through the linear polarizer 1 whose absorption axis is in vertical, and cannot emit light. Therefore, the reflection intensity of the external ambient light on the screen is reduced. After the foregoing steps, the external ambient light is blocked in the circular polarizer, so that the contrast of the OLED display panel is greatly improved, an outdoor visibility function of the OLED panel is implemented, and the content of the screen can be clearly viewed even under strong sunlight.

However, emergent light of the OLED structure is non-polarized light, and 50% of the vertical polarized light cannot pass through the linear polarizer, causing a loss in an amount of the emergent light of the OLED structure. Specifically, as shown in part (b) in FIG. 1, the emergent light of the OLED structure passes through the cathode layer 3 of the OLED structure and is emitted to the phase retardation film 2, and the emergent light includes 50% left-handed polarized light and 50% right-handed polarized light. Under an action of the phase retardation film 2, the left-handed polarized light and the right-handed polarized light are converted into horizontal polarized light and vertical polarized light respectively. The vertical polarized light is absorbed by the linear polarizer 1, and only the horizontal polarized light can be emitted to the outside through the linear polarizer 1.

In conclusion, the circular polarizer is an absorptive polarizer, and a light transmittance is about 50%, and is only about 43% in an actual application. Therefore, about 60% of light emitted by an OLED device is absorbed, and output efficiency of light of the OLED device is reduced. In other words, although the circular polarizer implements the outdoor visibility function of the OLED panel, the circular polarizer brings a problem of low output efficiency of light.

To resolve the foregoing problem, a color filter on thin film encapsulation (color filter on thin film encapsulation, CF on TFE, COE) technology is proposed in the industry. The COE is a new technology that can replace a polarizer, where a color filter is fabricated on a thin film encapsulation (thin film encapsulation, TFE) layer, so that ambient light can be suppressed, and output efficiency of light of a panel (panel) can be improved. A reflective index of the panel can be lowered by the color filter to a level equivalent to that of the circular polarizer, and light transmittance of the color filter can reach more than 60%, so that the output efficiency of light of the OLED panel can be improved by about 10% to 30%. In addition, compared with the polarizer, the color filter is lighter and thinner, and is also conducive to implementing lightening and thinning of the OLED panel, to implement a flexible display characteristic.

The following further describes the COE architecture in detail with reference to accompanying drawings. FIG. 2 is a schematic diagram of a structure of an OLED panel based on a COE architecture according to an embodiment of this application. The OLED display panel provided in this embodiment of this application includes a plurality of pixels arranged in an array. Each pixel includes at least three subpixels. Each subpixel may emit light of one color. The three subpixels may be an R subpixel that emits red light, a G subpixel that emits green light, and a B subpixel that emits blue light. A setting form of the subpixels may be set based on a color matching mode of the OLED display panel. For ease of description, FIG. 2 shows only one pixel of the OLED panel.

As shown in FIG. 2, the OLED panel successively includes a substrate 10, a thin film transistor array layer 20, an organic light emitting layer 30, a thin film encapsulation layer 40, an over coating (over coating, OC) layer 50, a color filter layer 60, a connection layer 70, a cover layer 80, and a functional layer 90.

The organic light emitting layer 30 includes a pixel define layer (pixel define layer, PDL) 31, subpixel light emitting units 32, an anode layer 33, and a cathode layer 34. The pixel define layer 31 is made of a black opaque material. A plurality of opening regions are formed inside the pixel define layer 31. The subpixel light emitting unit 32 is disposed in each opening region. The anode layer 33 is disposed on a side that is of the subpixel light emitting units 32 and that faces the substrate 10. The anode layer 33 is also located in the opening region defined by the pixel define layer 31. The cathode layer 34 is disposed on a side that is of the subpixel light emitting units 32 and that is away from the substrate 10. The cathode layer 34 has at least sufficient light transmittance, so that light emitted by the subpixel light emitting units 32 can be emitted outside through the cathode layer 34.

FIG. 2 shows three subpixel light emitting units 32 in one pixel, which are respectively the R subpixel that emits red light, the G subpixel that emits green light, and the B subpixel that emits blue light.

The thin film encapsulation layer 40 is located outside the organic light emitting layer 30, and is configured to prevent water vapor or oxygen from entering the organic light emitting layer 30 and causing damage to the organic light emitting layer 30. The overcoating layer 50 is configured to perform flattening (leveling) on the thin film encapsulation layer 40, to facilitate reliable disposing of the color filter layer 60 on the thin film encapsulation layer 40.

The color filter layer 60 includes color resistance units 62 and a black matrix (black matrix, BM) 61 located between adjacent color resistance units 62. The black matrix is made of a black opaque material, and light emitted by the subpixel light emitting units 32 can be emitted to the outside only through the color resistance units 62.

The color resistance units 62 are configured to allow light of a specific wavelength to pass through. There are a plurality of color resistance units 62, and the plurality of color resistance units are disposed with the plurality of subpixel light emitting units 32 in a one-to-one correspondence. Specifically, the color resistance unit 62 may include a red color resistance unit, a green color resistance unit, and a blue color resistance unit, which are disposed with the R subpixel, the G subpixel, and the B subpixel in a one-to-one correspondence, to form a color filter functional layer. The connection layer 70, the cover layer 80, and the functional layer 90 are sequentially disposed on an upper side of the color filter layer 60. The connection layer 70 is made of a highly transparent material, and is configured to fixedly connect the cover layer 80 to the color filter layer 60. The connection layer 70 may be made of, for example, optically clear adhesive (optically clear adhesive, OCA). The cover layer 80 is configured to provide mechanical support and protection for the panel, and the cover layer 80 may be, for example, a glass cover. The functional layer 90 is configured to implement a corresponding function. For example, the functional layer 90 may be an anti-reflection (anti-reflection, AR) layer that reduces light reflection.

In conclusion, when the OLED panel in FIG. 2 and a conventional OLED panel having a circular polarizer are compared, in the OLED panel shown in FIG. 2, the color filter layer 60 is used to replace the circular polarizer. This can not only suppress ambient light (reduces the reflective index of the panel under strong light), but also improve the output efficiency of light of the panel (where the output efficiency of light increases from 42% to 60%). In addition, the color filter layer 60 is lighter and thinner than the circular polarizer (where a thickness is reduced from 100 µm to 5 µm). This helps implement folding and bending characteristics of the OLED panel, and implement lightening and thinning of the panel.

With development of economy and progress of science and technology, a use requirement of a user for an electronic device is accordingly increasing. Although the output efficiency of light of the OLED panel using the COE architecture is improved to about 60%, the output efficiency of light of 60% still cannot meet the use requirement of the user in some cases. Currently, to achieve higher luminance, more power consumption needs to be provided for the OLED panel, and as a result, a service life of the OLED panel is reduced. Therefore, providing an OLED panel with higher output efficiency of light becomes an urgent problem to be solved.

When light is propagated to an interface between two media, reflection and refraction usually occur at the same time. When an incident angle exceeds a specific critical angle, refracted light completely disappears, and the light is no longer refracted and returns to the original medium for propagation. This phenomenon is referred to a total reflection phenomenon. Due to the existence of the total reflection phenomenon, the output efficiency of light of the OLED panel is difficult to be further improved. The following describes impact of the total reflection phenomenon on the output efficiency of light of the OLED panel with reference to the accompanying drawings.

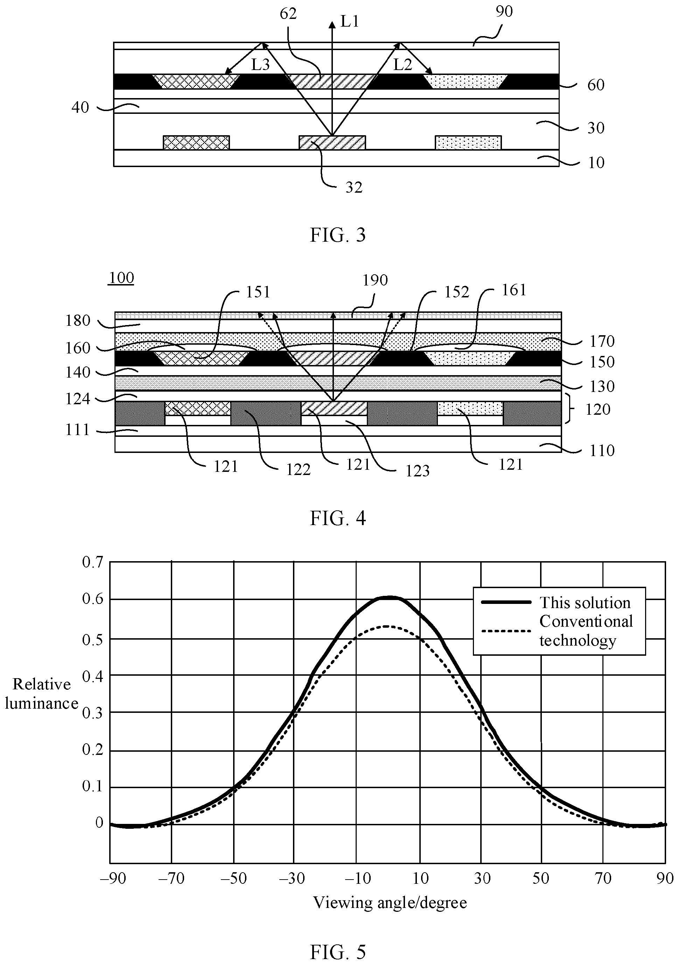

FIG. 3 is a schematic diagram of a principle of a total reflection phenomenon of light emitted by an OLED panel according to an embodiment of this application. For ease of description, compared with that in FIG. 2, the OLED panel in FIG. 3 has some structural simplifications. The simplifications do not constitute any limitation on the structure of the OLED panel provided in this embodiment of this application.

As shown in FIG. 3, the OLED panel includes a substrate 10, an organic light emitting layer 30, a thin film encapsulation layer 40, a color filter layer 60, a functional layer 90, and the like that are sequentially stacked directly or indirectly (by using an intermediate medium). The organic light emitting layer 30 includes a plurality of subpixel light emitting units 32. Light emitted by the subpixel light emitting units 32 sequentially passes through the thin film encapsulation layer 40 and a color resistance unit 62 on the color filter layer 60 and then is emitted to a top surface (outer surface) of the functional layer 90. The top surface of the functional layer 90 is an interface between the OLED panel and an external environment. Emitting light from the functional layer 90 to the air is equivalent to emitting light from an optically denser medium to an optically thinner medium. In this case, a total reflection phenomenon may occur.

The color resistance units 62 cover the subpixel light emitting units 32 in a one-to-one correspondence. An area of the color resistance units 62 is greater than a light emitting area of the subpixel light emitting units 32. The subpixel light emitting units 32 are equivalent to a point light source. Incident angles of the light emitted by the subpixel light emitting units 32 to the functional layer 90 after passing through the color resistance units 62 may be different. An incident angle of a part of the light is larger and an incident angle of a part of the light is smaller. When an incident angle exceeds a specific critical value, the total reflection phenomenon of the light is likely to occur.

For example, as shown in FIG. 3, first light L 1, second light L2, and third light L3 emitted by the subpixel light emitting units 32 pass through the color resistance units 62 and are emitted to the top surface of the functional layer 90. An incident angle (namely, an included angle between the light and a normal line of the top surface) of the second light L2 and an incident angle of the third light L3 exceed the critical angle, and the total reflection phenomenon occurs. In this case, refracted light of the second light L2 and the third light L3 completely disappear. The light is no longer refracted and returns to the inside of the panel for propagation. The reflected light is eventually absorbed by a material of the inside of the panel. In other words, for the first light L1, the second light L2, and the third light L3, only the first light L1 can pass through the functional layer 90 and be emitted to the outside.

In conclusion, due to the total reflection phenomenon, a part of the light emitted by the OLED panel may be reflected back to the inside of the panel by the interface between the panel and the environment, and finally absorbed and dissipated by the material of the inside of the panel. The part of the light on which the total reflection occurs cannot be emitted to the environment. Therefore, the output efficiency of light of the OLED panel is reduced, and the output efficiency of light of the OLED panel is difficult to be further improved. How to break the bottleneck and provide an OLED panel with higher output efficiency of light becomes a hot issue in the industry. To resolve the foregoing problem, embodiments of this application provide a display apparatus and an electronic device. A light converging structure is disposed in the display apparatus to converge light, so that more light can be extracted outside of the display apparatus, to improve output efficiency of light of the display apparatus.

According to a first aspect, an embodiment of this application first provides a display apparatus. The display apparatus includes but is not limited to a display panel. For example, the display apparatus may be the foregoing OLED display panel, or may be a display panel having a structure such as a micro light-emitting diode (micro light-emitting diode, micro-LED). This is not limited thereto.

FIG. 4 is a schematic diagram of a structure of an example of a display apparatus 100 according to an embodiment of this application. As shown in FIG. 4, the display apparatus 100 provided in this embodiment of this application includes a substrate 110, a light emitting layer 120, and a light converging layer 160.

The light emitting layer 120 is disposed on one side surface of the substrate 110. In a powered-on state, the light emitting layer 120 can emit light in a direction away from the substrate 110, that is, a vertical upward direction in FIG. 4 is an exit direction in which the light emitting layer 120 generates light. An upper side of the light emitting layer 120 is a light emitting side.

The light emitting layer 120 includes a plurality of pixel light emitting units (referred to as pixels) arranged in an array form. Each pixel includes at least three subpixel light emitting units (referred to as subpixels) 121. Each subpixel 121 may display light of one color.

In this embodiment of this application, each pixel includes three subpixels 121, which are respectively a red subpixel that can display (emit) red light, a green subpixel that can display green light, and a blue subpixel that can display blue light.

The light emitting layer 120 includes a plurality of subpixels 121 arranged in an array. For ease of description, only three subpixels 121 are shown in FIG. 4. Along a direction from left to right in FIG. 4, the three subpixels 121 are respectively a red subpixel, a green subpixel, and a blue subpixel, and the three subpixels 121 form one pixel. In other words, FIG. 4 shows only one pixel in the pixel array of the display apparatus 100.

A specific structure of the light emitting layer 120 may vary based on a type of the display apparatus 100. In this embodiment of this application, the display apparatus 100 is an OLED display panel, and the light emitting layer 120 is an organic light emitting layer. In this case, the subpixel 121 includes an organic light emitting diode.

In another implementation, the plurality of subpixels 121 may further include the foregoing W subpixels that can display white light. In other words, in this case, the display apparatus 100 may be in an RGBW color matching mode.

In another implementation, the display apparatus 100 may also be a micro-LED display panel. In this case, the subpixel 121 includes a micro light-emitting diode.

As shown in FIG. 4, the light emitting layer 120 may further include a pixel define layer 122, an anode layer 123, and a cathode layer 124. The pixel define layer is made of a black opaque material. A plurality of opening regions are formed inside the pixel define layer. One subpixel 121 is disposed in each opening region. The anode layer 123 is disposed on a side that is of the subpixel 121 and that faces the substrate 110. The anode layer 123 is also located in the opening region defined by the pixel define layer 122. The cathode layer 124 is disposed on a side that is of the subpixel 121 and that is away from the substrate 110. The cathode layer 124 is located on a light output side of the subpixel 121. Therefore, the cathode layer 124 should have sufficient light transmittance, so that light emitted by the subpixel 121 can be emitted outside through the cathode layer 124.

As shown in FIG. 4, to supply power to the light emitting layer 120, a circuit layer 111 may be further disposed between the substrate 110 and the light emitting layer 120. The circuit layer 111 may be, for example, a thin film transistor array layer. The substrate 110 may be made of any material such as glass, ceramic, plastic, metal, or rubber. This is not limited in this application. In a possible implementation, the substrate 110 may be made of a flexible material, for example, made of polyimide (polyimide, PI), so that the substrate 110 can be bent and deformed, and the display apparatus 100 can meet a use requirement of a foldable terminal device (for example, a foldable mobile phone).

As shown in FIG. 4, the light converging layer 160 is disposed on a side that is of the light emitting layer 120 and that is away from the substrate 110, that is, the light converging layer 160 is disposed on a light output side of the light emitting layer 120. The light converging layer 160 includes a plurality of light converging structures 161. The plurality of light converging structures 161 cover the plurality of subpixels 121 in a one-to-one correspondence. The light converging structures 161 are configured to gather light emitted by the subpixels 121 covered by the light converging structures 161. For example, the light converging structure 161 is configured to converge light emitted by the subpixel 121 in a direction of a normal line (an axis or a center line) of the light converging structure 161. In other words, the light is converged toward an inner side of an orthographic projection of the light converging structure 161 toward an outer surface of the apparatus.

In this embodiment of this application, each light converging structure 161 correspondingly covers one subpixel 121. The light emitted by the subpixel 121 can be emitted to the outer surface of the display apparatus 100 through the light converging structure 161. The outer surface is an interface between the apparatus and an external environment, and is also an interface that is between an optically denser medium and an optically thinner medium and where total reflection is easy to occur. Under a refraction action of the light converging structure, a part of the light emitted by the subpixel 121 can be converged in a direction of the normal line (the inner side) of the light converging structure, so that an incident angle of this part of the light entering the outer surface of the display apparatus 100 is reduced. Therefore, the incident angle of this part of the light is less than a critical value of a total reflection phenomenon, so that the total reflection phenomenon of the light in the apparatus is reduced or completely avoided, and more light can pass through the outer surface of the apparatus and enter the environment. As a result, the output efficiency of light of the display apparatus 100 is improved.

Herein, the light converging structure 161 covers the subpixel 121, and may cover the entire subpixel 121 (that is, complete coverage), or may cover a part of the subpixel 121 (that is, partial coverage). This is not limited in this application. The coverage mentioned below shall include the full coverage and the partial coverage.

According to the display apparatus 100 provided in this embodiment of this application, the light converging layer 160 including an array of light converging structures 161 is disposed in the display apparatus 100, to converge the light emitted by the subpixels 121 of the light emitting layer 120. The light converging structures 161 cover the subpixels 121 in a one-to-one correspondence. Each light converging structure 161 converges (gathers) light emitted by a corresponding subpixel 121 of the light converging structure 161, so that light of a part of a large viewing angle is transferred to a small viewing angle, and light that should be completely reflected and dissipated in the apparatus is extracted to the outside of the apparatus. As a result, the output efficiency of light of the display apparatus 100 is improved.

The display apparatus 100 provided in this embodiment of this application has higher output efficiency of light, and can meet a use requirement of a user for an apparatus with high luminance. Because the output efficiency of light is higher, not only power consumption of the apparatus can be reduced, but also a service life of the apparatus can be prolonged.

For ease of understanding and description, in a specific example, as shown in FIG. 4, three light rays emitted by the subpixel 121 in the middle are emitted to the outer surface of the apparatus through the light converging structure 161. If the light converging structure 161 is not disposed, two light rays on the left side and on the right side are directly emitted to the outer surface in a direction indicated by a dotted arrow in the figure. In this case, an incident angle of the two light rays is large, which may exceed a critical value and cause total reflection. Once total reflection occurs, these two light rays are reflected back to the inside of the apparatus and are eventually absorbed and dissipated by the material inside the apparatus.

In this application, after the light converging structure 161 is disposed, the two light rays are converged in a direction of a central axis (a central line, that is, an inner side of a projection of the light converging structure 161) of the light converging structure 161, and finally are emitted to the outer surface of the panel in a direction indicated by a solid arrow. In this case, an incident angle of the two light rays is obviously reduced, and a total reflection phenomenon does not occur. The two light rays are emitted to the outside of the apparatus together with the light ray in the middle, so that the output efficiency of light of the apparatus is improved.

Optionally, in another implementation, each light converging structure 161 may also correspondingly cover a plurality of subpixels 121. Alternatively, a plurality of light converging structures 161 (for example, arranged in parallel or stacked) may simultaneously cover one subpixel 121. All of the foregoing settings can converge light emitted the subpixel 121, and should fall within the protection scope of this application.

It should be noted that, when each light converging structure 161 covers a plurality of subpixels 121, the light converging structure 161 converges the light emitted by the plurality of subpixels 121 as a whole in a direction of a normal line or a center line (an inner side of an orthographic projection) of the light converging structure 161. That is, a reference object of convergence is relative to the light converging structure 161.

In other words, in the description of this application, that a plurality of light converging structures 161 cover a plurality of subpixels 121 should include at least one of the following three cases: a plurality of light converging structures 161 cover a plurality of subpixels 121 in a one-to-one correspondence (one-to-one); each light converging structure 161 covers a plurality of subpixels 121 (one-to-many); and a plurality of light converging structures 161 simultaneously cover one subpixel 121 (many-to-one). A person skilled in the art may select one or more of the foregoing combinations based on a specific requirement to converge the light of the subpixel 121.

FIG. 5 is a comparison diagram of effect simulation between a display apparatus 100 according to an embodiment of this application and a display apparatus in the conventional technology; As shown in FIG. 5, under a same test condition, computer simulation is performed by using the display apparatus 100 provided in embodiments of this application and an existing conventional display apparatus on which no light converging structure is disposed, to obtain relative luminance of the apparatus at different viewing angles.

A simulation result shows that luminance (that is, output efficiency of light) of the display apparatus 100 provided in embodiments of this application is obviously better than that of the existing conventional display apparatus. In different viewing angles, relative luminance of the display apparatus 100 provided in embodiments of this application is almost all greater than relative luminance of the existing conventional display apparatus. When a viewing angle is 0 degrees, a luminance improvement effect of the display apparatus 100 provided in embodiments of this application is most obvious compared with the existing conventional display apparatus, and the luminance improvement reaches more than 20%. In the display apparatus 100 provided in embodiments of this application, output efficiency of light of the apparatus can be effectively improved by disposing the light converging structure 161.

The following further describes a specific structure of the display apparatus 100 provided in embodiments of this application with reference to the accompanying drawings.

As shown in FIG. 4, the display apparatus 100 further includes an encapsulation layer 130, an overcoating layer 140, and a light filtering layer 150 that are sequentially stacked on the light emitting layer 120, and the light converging layer 160 is disposed on a light output side of the light filtering layer 150.

The encapsulation layer 130 may be a thin film encapsulation layer. The encapsulation layer 130 is configured to encapsulate and protect the light emitting layer 120, to prevent impurities such as water vapor and oxygen from entering the light emitting layer 120 and causing erosion damage to the light emitting layer 120.

The encapsulation layer 130 may be formed by one layer of thin film structure or by superimposing a plurality of layers of thin film structures. For example, the encapsulation layer 130 may include at least one inorganic material layer and/or an organic material (such as silicon nitride or silicon oxide) layer.

The overcoating layer 140 is configured to perform flattening processing on the encapsulation layer 130, to facilitate reliable disposing of the light filtering layer 150 on the encapsulation layer 130.

The overcoating layer 140 is made of a highly light-transmitting material, and has a total light transmittance of 99% or more.

Optionally, the overcoating layer 140 may be made of sat least one material of an acrylic resin, an epoxy resin, a phenol-formaldehyde resin, a polyurethane, a polyamide resin, a polyimide resin, an unsaturated polyester, and the like.

The light filtering layer 150 is disposed between the light emitting layer 120 and the light converging layer 160. The light filtering layer 150 includes a plurality of color resistance units 151 and a black matrix 152 surrounding the color resistance units 151. The plurality of color resistance units 151 cover the plurality of subpixels 121 in a one-to-one correspondence.

Specifically, the color resistance unit 151 is configured to allow light of a specific wavelength to pass through, and the plurality of color resistance units 151 include a red color resistance unit, a green color resistance unit, and a blue color resistance unit. The plurality of color resistance units 151 are in a one-to-one correspondence with the plurality of subpixels 121. The red color resistance unit covers a subpixel 121 that emits red light, the green color resistance unit covers a subpixel 121 that emits green light, and the blue color resistance unit covers a subpixel 121 that emits blue light. That is, corresponding to the three subpixels 121 in FIG. 4, along a direction from left to right in FIG. 4, the three color resistance units in the figure are respectively the red color resistance unit, the green color resistance unit, and the blue color resistance unit.

The black matrix 152 is disposed around the color resistance unit 151, and a black matrix 152 is disposed in each of two adjacent color resistance units 151. In other words, a plurality of openings are disposed on the black matrix 152, and a color resistance unit 151 is disposed in each opening. A color of the color resistance unit 151 corresponds to a light emitting color of a subpixel 121 covered by the color resistance unit 151.

The black matrix 152 is made of a black opaque material, for example, a black resin material. The light emitted from the subpixel 121 can only pass through the color resistance unit 151 to the outside of the panel.

Optionally, the color resistance unit 151 may be a color filter. The red color resistance unit, the green color resistance unit, or the blue color resistance unit are respectively a red color filter, a green color filter, or a blue color filter. A thickness of the color filter may be 1 to 5 microns. The color filter can be formed by a mature process such as spin coating or inkjet printing. Optionally, a thickness of the black matrix 152 is 1.5 to 5 microns, a proportion of an area occupied by the black matrix 152 in the light filtering layer 150 is greater than 50%, for example, 75% to 85%, and the thickness of the black matrix 152 may be the same as the thickness of the color filter. In the display apparatus 100 provided in this embodiment of this application, the light filtering layer 150 is disposed, and a polarizer configured to prevent reflection of ambient light does not need to be disposed on a light output side of the light emitting layer 120. This can improve the output efficiency of light of the display apparatus 100, reduce power consumption of the display apparatus 100, and prolong the service life of the display apparatus 100.

As shown in FIG. 4, the light converging structures 161 cover the color resistance units 151 in a one-to-one correspondence. A position deviation between a center of the light converging structure 161 and a center of the color resistance unit 151 is less than or equal to 5 microns. An area percentage between the light converging structure 161 and the color resistance unit 151 is 0.6 to 2.2.

Through the foregoing setting, it can be ensured that at least a majority (for example, more than 80% of an area) of the color resistance unit 151 is covered by the light converging structure 161, so that the light converging structure 161 can converge most light that passes through the color resistance unit 151, to help improve the output efficiency of light of the panel.

The light filtering layer 150 may be manufactured by using a low-temperature color filter process, and a manufacturing temperature is lower than 100°C. The manufacturing process is as follows: A black matrix 152 for anti-reflection is formed on the overcoating layer 140, and the black matrix 152 is cleaned and then applied with a photoresist. After a red photoresist is coated, a red color filter (red color resistance unit) is formed through exposure, development and baking. Then, a green color filter and the blue color filter are formed in sequence.

It should be noted that the display apparatus 100 provided in this embodiment of this application is a display apparatus in a COE architecture. However, the display apparatus 100 is not limited to the COE architecture, and may also be another architecture. For example, in another implementation, the display apparatus 100 may not include the light filtering layer 150. This is not limited in this application. The light converging layer 160 includes a plurality of light converging structures 161 arranged in an array. A specific structure of the light converging structures 161 is not limited in this application. Any optical element that has a light converging function shall fall within the protection scope of this application. The light converging structure 161 can extract more light to the outside of the apparatus, so the light converging structure in this application may also be referred to as a light obtaining microstructure.

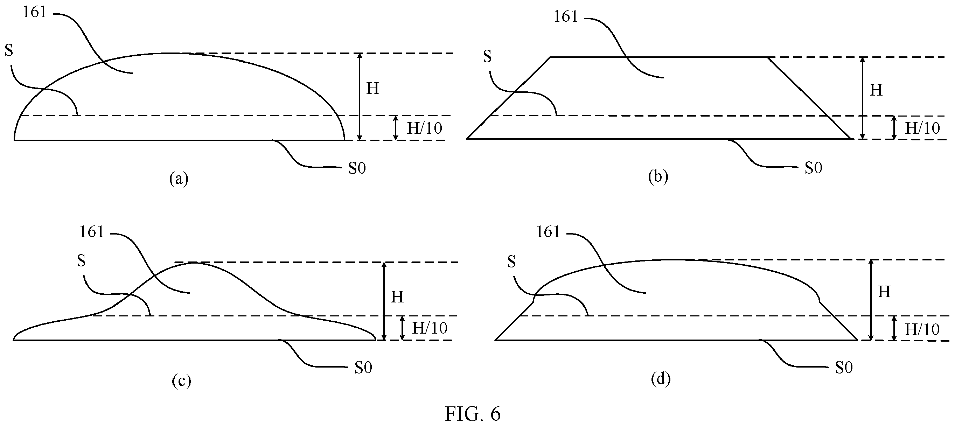

FIG. 6 is a schematic diagram of a cross section of a light converging structure 161 according to an embodiment of this application. As shown in FIG. 6, the light converging structure 161 provided in this embodiment of this application may be an optical element of any regular or irregular shape that can converge light.

As shown in FIG. 6, a height H of the light converging structure 161 provided in this embodiment of this application is greater than or equal to 2 microns, so that the light converging structure has a better light converging effect.

As shown in part (a) in FIG. 6, part (c) in FIG. 6, and part (d) in FIG. 6, the light converging structure 161 may be a light converging microlens, such as a light converging convex lens. In this case, the height H of the light converging structure 161 refers to a distance from a bottom surface S0 of the light converging structure 161 to an apex of the light converging structure 161. The bottom surface is planar. In other words, the bottom surface is a side surface of the light converging structure 161 that faces the subpixel 121, a side surface adjacent to the color resistance unit 151, and a light input side of the light converging structure 161. The apex is far away from the subpixel 121, and is a light output side of the light converging structure 161. A direction from the bottom surface S0 of the light converging structure 161 to the apex of the light converging structure 161 is an exit direction of the light, that is, a thickness direction of the display apparatus 100.

As shown in part (b) of FIG. 6, a cross section of the light converging structure 161 may also be in a ladder shape, and has a top surface and a bottom surface S0, both of which are planar. In this case, the height H of the light converging structure 161 refers to a distance from the bottom surface S0 of the light converging structure 161 to the top surface of the light converging structure 161. The bottom surface S0 is attached to the color resistance unit 151.

As shown in FIG. 6, a cross-sectional area of the light converging structure 161 may vary depending on the height. In this embodiment of this application, a cross-sectional area S at a height of 10% (that is, H/10) of a total height of the light converging structure 161 is defined as an area of the light converging structure 161. That is, for the light converging structures 161 of different structures shown in FIG. 6, the cross-sectional area S at H/10 is the area of the light converging structures 161.

Further, in this embodiment of this application, a percentage of the area of the light converging structure 161 (that is, the cross-sectional area at the height of 10% of the total height) to a light emitting area of a subpixel 121 corresponding to the light converging structure 161 is 0.6 to 2.2. Through the foregoing setting, it can be ensured that most (for example, more than 60% of the area) of the light emitted by the subpixel 121 is covered by the light converging structure 161, so that the light converging structure 161 can converge most of the light, and this helps improve the output efficiency of light of the apparatus.

Optionally, the light converging structure 161 is a convex lens, and a vector height of the convex lens is greater than or equal to 2 microns, so that the light converging structure 161 has a better light converging effect.

Optionally, a surface type of a convex surface of the convex lens may be any one of a spherical surface, an ellipsoidal surface, a parabolic surface, a free-form surface, or the like.

Optionally, a material of the light converging structure 161 may be an acrylic acid resin, a polyimide resin, a siloxane resin, a phenol-formaldehyde resin, a resin system compounded with a metal nanoparticle, or the like. This is not limited in this application.

In this embodiment of this application, the plurality of light converging structures 161 cover the plurality of subpixels 121 (that is, the plurality of color resistance units 151) in a one-to-one correspondence. A quantity of the light converging structures 161 may be equal to or less than a quantity of the subpixels 121.

Optionally, the quantity of light converging structures 161 is the same as the quantity of subpixels 121. In this case, each subpixel 121 is covered by the light converging structure 161. That is, the red subpixel, the green subpixel, and the blue subpixel are all covered by the light converging structure 161.

Optionally, the quantity of light converging structures 161 is less than the quantity of subpixels 121. In this case, only some of the subpixels 121 are covered by the light converging structures 161, but not all of the subpixels 121.

For example, the plurality of light converging structures 161 cover the plurality of blue subpixels in a one-to-one correspondence, that is, the plurality of light converging structures 161 of the light converging layer cover only the blue subpixel, but do not cover the red subpixel or the green subpixel. Because light emitting power consumption of the blue subpixel accounts for almost half of working power consumption of the whole panel, under a premise that a quantity of lenses is limited, the light converging structure 161 only covers the blue subpixel and performs light obtaining, so that the light emitting power consumption of the blue subpixel can be effectively reduced, and overall power consumption of the panel is reduced to a maximum extent.

In addition, the light converging structure 161 covers only the blue subpixel, which also helps reduce setting density of the light converging structure 161, and further helps reduce processing difficulty of the light converging layer 160 in the manufacturing process.

Optionally, in another implementation, the light converging structure 161 may also cover some subpixels 121 in any manner based on an actual requirement, for example, cover only the red subpixel and/or the green subpixel. This is not limited in this application.

In this embodiment of this application, the light converging layer 160 (that is, the light converging structure 161) may be formed and processed by using a yellow light process. A specific technological process is as follows:
First, a surface of the light filtering layer 150 is cleaned to remove foreign matter on the surface and improve hydrophilicity on the surface to avoid coating defects. Then, photoresist film forming coating is carried out by a coating device to form an entire photoresist film. Then, a soft baking device is used to preliminarily solidify the photoresist and connect the photoresist to a substrate, and a part of chemical solution components inside the photoresist are removed. Then position accuracy and pattern are defined based on exposure spacing and exposure energy by using a photolithographic mask. Then, the pattern after lithography is developed by using a developing device based on a developing temperature and a developing time. Finally, a hard-baking process is performed to finally solidify the light converging structure 161 to avoid abnormality in a subsequent process.

As shown in FIG. 4, the display apparatus 100 further includes a protective layer 170. The protective layer 170 is disposed on a side that is of the light converging layer 160 and that is away from the substrate 110. A refractive index of the light converging structure 161 is greater than a refractive index of the protective layer. The protective layer 170 covers the light converging layer 160, and can isolate and protect the light converging structure 161.

The protective layer 170 is made of a material with high light transmittance, for example, may be optically clear adhesive (optically clear adhesive, OCA). The optically clear adhesive is a double-sided adhesive tape without a base material, and has a characteristic such as colorlessness and transparency, high light transmittance (total light transmittance > 99%), high adhesion, high temperature resistance, ultraviolet resistance, and the like. The optically clear adhesive has a controlled thickness, can provide uniform spacing, and long-term use does not produce yellowing, peeling and deterioration problems.

Optionally, the optically clear adhesive may be liquid optical clear adhesive (liquid optical clear adhesive, LOCA). The LOCA is a liquid glue that is colorless and transparent after curing, has a light transmittance of more than 98%, and has a characteristic such as low curing shrinkage and yellowing resistance. In the field of full lamination, compared with traditional OCA tape, LOCA has unique advantages in large size, curved surface, harsh environment and other fields. For example, the LOCA may be an optical clear resin (optical clear resin, OCR).

Optionally, the protective layer 170 may be made of sat least one material of an acrylic resin, an epoxy resin, a phenol-formaldehyde resin, a polyurethane, a polyamide resin, a polyimide resin, an unsaturated polyester, and the like, and total light transmittance of the protective layer 170 is greater than or equal to 99%.

Optionally, a difference between the refractive index of the light converging structure 161 and the refractive index of the protective layer 170 is 0.1 to 0.5. Through the foregoing setting, the light converging structure 161 can have a better light converging effect.

In embodiments of this application, the refractive index of the light converging structure 161 ranges from 1.6 to 1.8, and the refractive index of the protective layer 170 range from 1.4 to 1.55. The display apparatus 100 provided in this embodiment of this application further includes a scattering layer. The scattering layer is disposed on a side that is of the light converging layer 160 and that is away from the substrate 110. A haze (haze) value of the scattering layer is 20% to 70%, for example, the haze value is 40% to 55%.

In a COE architecture, a diffraction problem may easily occur when light that is incident inside the panel is reflected. As a result, a colorful diffraction color pattern is generated under strong light (for example, under a point light source or sunlight or a lamp) in an external environment, and reading experience is seriously affected. In this application, the scattering layer is disposed on the light output side of the light emitting layer 120, so that a regular diffraction pattern can be dispersed, to eliminate a diffraction problem and improve reading experience of the user.

Further, as shown in FIG. 4, the heat dissipation layer is formed by scattering particles dispersed inside the protective layer 170. The scattering particles are evenly distributed inside the protective layer 170 (where distribution uniformity is greater than 85%), and the haze value of the heat dissipation layer may be adjusted based on a concentration of the scattering particles. Specifically, the scattering particles are doped in a manufacturing process of the protective layer 170. A size of the scattering particles is greater than 2 microns and less than half of a length of a shortest side of the subpixel. A material of the scattering particle may be an organic scattering particle such as cross-linked polystyrene (polystyrene, PS), cross-linked polymethyl methacrylate (polymethyl methacrylate, PMMA), organic silicon polymer, or may be an inorganic scattering particle such as titanium dioxide. The scattering particles need to be fully mixed in a sample preparation process to ensure that distribution uniformity of the scattering particles is greater than 85%. A method of adjusting the haze value can be achieved by controlling a percentage of matrix resin to the scattering particles.

Optionally, the scattering particle is in a spherical structure, and a diameter of the spherical structure is 1 to 3 microns. Therefore, the diffraction problem can be eliminated more effectively. As shown in FIG. 4, the display apparatus 100 further includes a cover layer 180 and a functional layer 190 that are sequentially stacked and disposed on the protective layer 170.

The cover layer 180 is configured to provide mechanical support and protection for the panel, and the cover layer 180 may be, for example, a glass cover. The functional layer 190 is configured to implement a corresponding function, and the functional layer 190 may be formed by stacking one or more layers of thin films.

For example, the functional layer 190 may include an antireflection layer configured to reduce light reflection. The antireflection layer can reduce reflection of a panel surface, improve a contrast percentage of an image of the display apparatus 100, improve a color gamut of a displayed image, and avoid problems such as visual color cast in a screen-off state.

The antireflection layer may be made by using an existing mature dry or wet process, and a material of the antireflection layer may be, for example, silicon oxynitride or silicon dioxide.

For another example, the functional layer 190 may further include an anti-glare (anti-glare, AG) layer. In this application, the AG layer is disposed, so that a problem that the display apparatus 100 generates reflection and glare under an ambient light source can be resolved, and image quality can be improved. The AG layer can reduce ambient light interference, improve a viewing angle and luminance of the displayed image, reduce screen reflection, and make the image clearer, more colorful, and more saturated, to significantly improve a display effect of the panel.

For another example, the functional layer 190 may further include an anti-fingerprint (anti-fingerprint, AF) layer. In this application, the AF layer is disposed, so that surface tension of the cover layer 180 can be minimized. As a result, the cover layer 180 has strong hydrophobic, oil-phobic, and anti-fingerprint capabilities, so that an effect of poor adhesion of a surface stain of an electronic product and easy cleaning can be further achieved.

For example, the AF layer may be a fluoroether-based fingerprint resistant layer capable of reducing sweat contamination.

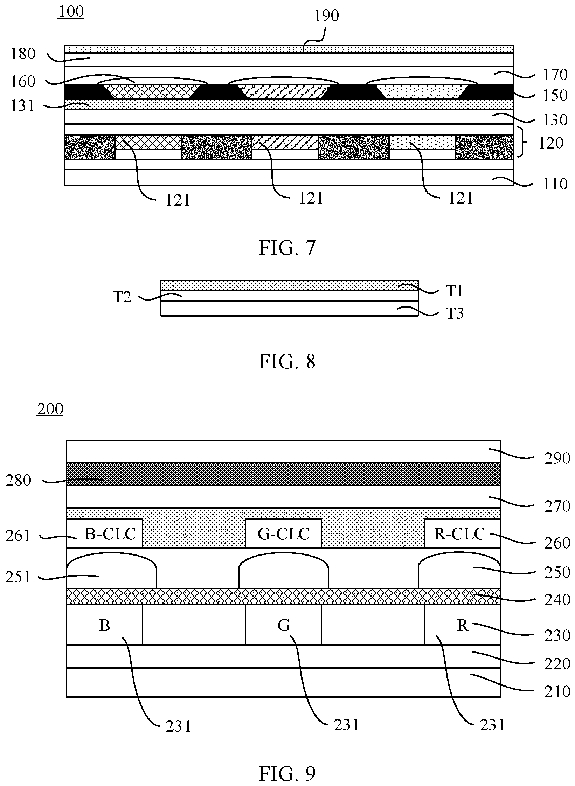

FIG. 7 is a schematic diagram of a structure of another example of a display apparatus 100 according to an embodiment of this application. As shown in FIG. 7, compared with the embodiment shown in FIG. 4, in this embodiment, the scattering layer 131 is disposed between the encapsulation layer 130 and the light converging layer 160. That is, in the embodiment shown in FIG. 4, the scattering layer is located on the light output side of the light converging layer 160. After the light converging layer 160 converges light emitted by the light emitting layer 120, the scattering layer performs scattering processing on the light. However, in this embodiment, the scattering layer 131 is located on the light incident side of the light converging layer 160. After the scattering layer 131 scatters the light emitted by the light emitting layer 120, the light converging layer 160 performs convergence processing on the light. Compared with the embodiment shown in FIG. 4, luminance of a front viewing angle of the display apparatus 100 provided in this embodiment is higher.

Optionally, a haze value of the scattering layer 131 may be 5% to 85%. Similarly, the scattering layer 131 may also be formed by doping scattering particles inside a light-transmitting material such as a resin. For material selection, manufacturing process, and the like of the scattering layer 131, refer to the description in the foregoing embodiment, and details are not described herein again.

Further, the display apparatus 100 further includes a touch (touch on TFE, TOE) layer. The touch layer is disposed between the encapsulation layer 130 and the light converging layer 160. The touch layer includes an overcoating layer. The scattering layer 131 is formed by scattering particles dispersed inside the overcoating layer.

In this embodiment of this application, the overcoating layer of the touch layer is reused, and the scattering particles are dispersed inside the overcoating layer to form the scattering layer 131. This helps reduce an overall thickness of the display apparatus 100.

FIG. 8 is a schematic diagram of a structure of a touch layer according to an embodiment of this application. As shown in FIG. 8, the touch layer includes a buffer (buffer) layer T3, a second overcoating layer T2, and a first overcoating layer T1 that are sequentially stacked. A thickness of the first overcoating layer T1 and a thickness of the second overcoating layer T2 are both about two microns. The first overcoating layer T1 and/or the second overcoating layer may be reused. In other words, scattering particles may be doped in the first overcoating layer T1 and/or the second overcoating layer to form the scattering layer 131. On the premise that normal operation of the touch layer is not affected, an effect of eliminating partial diffraction can be achieved.

As shown in FIG. 1, the OLED display panel reflects light under indoor or external strong light due to an internal metal electrode structure, which causes interference in reading, and is not dark in a dark state. Generally, a circular polarizer capable of resisting ambient light reflection is added externally. Reflected light of the OLED cathode is adjusted to a polarization state at which the light cannot pass through the linear polarizer through a combination of the linear polarizer and a phase compensation film. However, emergent light of the OLED is non-polarized light, and 50% of the vertical polarized light cannot pass through the linear polarizer, causing a loss in light extraction of the OLED display panel.

In the display apparatus 100 provided in the embodiments shown in FIG. 4 to FIG. 8, the light filtering layer 150 is disposed to replace a conventional circular polarizer, and the light converging layer 160 is further disposed on the light filtering layer 150 to converge light, so that the output efficiency of light of the display apparatus 100 is improved.

An embodiment of this application further provides a display apparatus. The display apparatus may retain a circular polarizer, but a cholesteric liquid crystal (cholesteric liquid crystal, CLC) layer is disposed inside the display apparatus to selectively reflect left-handed polarized light or right-handed polarized light to a light emitting layer of the apparatus. The light emitting layer of the apparatus rotates and reflects the reflected left-handed or right-handed polarized light again. Further, both left-handed and right-handed polarized light emitted by the light emitting layer can finally pass through the circular polarizer and be emitted to the outside of the panel, so that output efficiency of light of the display apparatus is improved.

The cholesteric liquid crystal layer (also called chiral light emitting layer) is a key to implement the technical effect. A cholesteric liquid crystal includes a substrate and a liquid crystal. Liquid crystal molecules of the cholesteric liquid crystal are flat and arranged into layers, the molecules in the layer are parallel to each other. A molecular major axis is parallel to a plane of the layer. Directions of molecular major axes of different layers are slightly changed. The molecular major axis is arranged in a spiral structure along a normal direction of the layer. Polarization selectivity can be achieved based on a structure of the cholesteric liquid crystal.

The cholesteric liquid crystal reflects circular polarized light (left-handed or right-handed) in one rotation direction and transmits circular polarized light (right-handed or left-handed) in the other direction for light in a specific wavelength range. A wavelength range of the cholesteric liquid crystal is determined by a product of a refractive index difference Δn and a liquid crystal molecule period pitch. For light beyond operating wavelength, the cholesteric liquid crystal can only transmit the light but cannot reflect the light. In this embodiment of this application, the cholesteric liquid crystal may be configured, so that an operating waveband of the cholesteric liquid crystal layer includes but is not limited to a blue light waveband, a green light waveband, a red light waveband, or an entire visible light waveband.

When a pitch rotation direction of the cholesteric liquid crystal is left-handed, right-handed polarized light (also referred to as right-handed circular polarized light) is allowed to be transmitted, and left-handed polarized light (also referred to as left-handed circular polarized light) can be reflected to the light emitting layer of the panel. Alternatively, when a pitch rotation direction of the cholesteric liquid crystal is right-handed, left-handed polarized light is allowed to be transmitted, and right-handed polarized light can be reflected to the light emitting layer of the panel.

FIG. 9 is a schematic diagram of a structure of a display apparatus 200 according to an embodiment of this application. As shown in FIG. 9, the display panel 200 includes a substrate 210, and a circuit layer 220, a light emitting layer 230, an encapsulation layer 240, a light converging layer 250, a cholesteric liquid crystal layer 260, a circular polarizer 270, a connection layer 280, and a cover layer 290 that are sequentially stacked on the substrate 210. For the substrate 210, the circuit layer 220, the light emitting layer 230, the encapsulation layer 240, the light converging layer 250, the connection layer 280, and the cover layer 290, refer to the foregoing related descriptions. This application focuses on the cholesteric liquid crystal layer 260 and the circular polarizer 270.

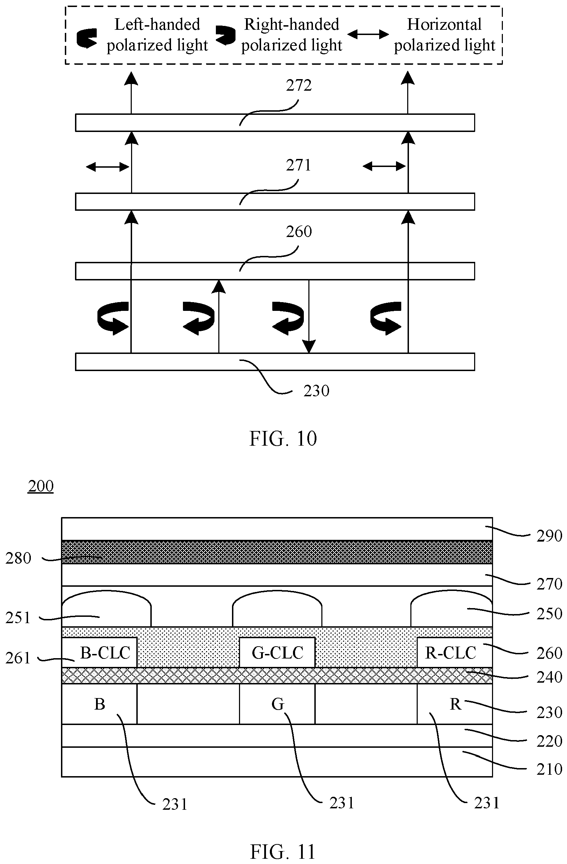

FIG. 10 is a schematic diagram of an operation principle of the cholesteric liquid crystal layer 260. As shown in FIG. 9 and FIG. 10, the cholesteric liquid crystal layer 260 is disposed on a side that is of the light emitting layer 230 and that is away from the substrate 210. The cholesteric liquid crystal layer 260 is configured to reflect, back to the light emitting layer 230, light emitted by a subpixel 231 of the light emitting layer 230 in a second rotation direction, and allow light in a first rotation direction to pass through. The light emitting layer 230 includes a metal material layer (for example, a cathode layer). Based on a characteristic of the light emitting layer 230, the light emitting layer 230 (for example, the cathode layer) can rotate the light in the second rotation direction to the first rotation direction and reflect the light to the cholesteric liquid crystal layer. The light in the first rotation direction obtained by the rotation of the light emitting layer 230 can pass through the cholesteric liquid crystal layer 260.

The circular polarizer 270 includes a phase retardation film 271 and a linear polarizer 272. The light emitted from the cholesteric liquid crystal layer 260 is first emitted to the phase retardation film 271. The circular polarizer 270 is disposed on a side that is of the cholesteric liquid crystal layer and that is away from the substrate 210. The phase retardation film 271 is configured to convert the light in the first rotation direction into vertical polarized light or horizontal polarized light that can pass through the linear polarizer 272.

In this embodiment of this application, the light in the first rotation direction is the left-handed polarized light, and the light in the second rotation direction is the right-handed polarized light. In this case, the cholesteric liquid crystal layer 260 can reflect the right-handed polarized light emitted by the subpixel 231 of the light emitting layer 230 back to the light emitting layer 230, and transparently transmit the left-handed polarized light. The light emitting layer 230 rotates the right-handed polarized light to the left-handed polarized light, and then reflects the left-handed polarized light back to the cholesteric liquid crystal layer 260.

Specifically, as shown in FIG. 10, emergent light of the light emitting layer 230 is natural light, including 50% left-handed polarized light and 50% right-handed polarized light. After the light is transmitted to the cholesteric liquid crystal layer 260, the 50% left-handed polarized light is transmitted directly through the cholesteric liquid crystal layer 260 to the phase retardation film 271. The phase retardation film 271 converts this part of the light into horizontal polarized light and transmits to the linear polarizer 272. The linear polarizer 272 is an absorptive polarizer (absorptive polarizer), and has a function of shielding and transmitting incident light, so that horizontal polarized light can be transmitted, and vertical polarized light can be shielded (blocked). Optionally, the linear polarizer 272 may be a metal wire grid polarizer, a multi-layer double refraction polymer film polarizer, or a MacNeille polarizer.

The right-handed polarized light emitted by the light emitting layer 230 cannot pass through the cholesteric liquid crystal layer 260, but is reflected back to the light emitting layer 230 by the cholesteric liquid crystal layer 260. The light emitting layer 230 rotates the right-handed polarized light into the left-handed polarized light and then reflects the left-handed polarized light back to the cholesteric liquid crystal layer 260. In this case, this part of the light may pass through the cholesteric liquid crystal layer 260, the phase retardation film 271, and the linear polarizer 272, and then be emitted to the outside of the apparatus.

According to the display apparatus 200 provided in this embodiment of this application, the cholesteric liquid crystal layer 260 is disposed between the light emitting layer 230 and the circular polarizer 270 to selectively reflect left-handed polarized light or right-handed polarized light to the light emitting layer of the apparatus. The light emitting layer rotates and re-reflects the reflected left-handed or right-handed polarized light, so that both the left-handed polarized light and the right-handed polarized light emitted by the light emitting layer 230 can finally be emitted to the outside of the apparatus through the circular polarizer 270, to improve the output efficiency of light of the display apparatus 200.

Optionally, in another implementation, the light in the first rotation direction may be right-handed polarized light, and the light in the second rotation direction is left-handed polarized light. In this case, configuration (a helix direction) of the cholesteric liquid crystal layer 260 can be changed, so that the cholesteric liquid crystal layer 260 can reflect the left-handed polarized light and transparently transmit right-handed polarized light. The linear polarizer 272 is configured to transmit vertical polarized light and shield (block) horizontal polarized light.

As shown in FIG. 9, in this embodiment of this application, the cholesteric liquid crystal layer 260 is located on a side that is of the light converging layer 250 and that is away from the substrate 210. In other words, the cholesteric liquid crystal layer 260 is located on a light output side of the light converging layer 250.

FIG. 11 is a schematic diagram of a structure of another example of a display apparatus 200 according to an embodiment of this application. In the embodiment shown in FIG. 11, the cholesteric liquid crystal layer 260 may be located between the light converging layer 250 and the substrate 210. In other words, the cholesteric liquid crystal layer 260 may be located on a light incident side of the light converging layer 250. A relative position of the light converging layer 250 and the cholesteric liquid crystal layer 260 is not limited in embodiments of this application. As shown in FIG. 9, in this embodiment of this application, the cholesteric liquid crystal layer 250 includes a plurality of liquid crystal patterns 261, and the plurality of liquid crystal patterns 261 cover a plurality of subpixels 231 in a one-to-one correspondence.

In this case, operating wavebands of the plurality of liquid crystal patterns 261 correspond to display wavebands of the plurality of subpixels 231 one by one. A liquid crystal pattern 261 (B-CLC) whose operating waveband is a blue light waveband covers a subpixel 231 (B) displaying blue light. The liquid crystal pattern 261 (B-CLC) is configured to reflect, back to the light emitting layer 230, light emitted by the subpixel 231 in a second rotation direction (right-hand) in the blue light, and allow light in a first rotation direction (left-hand) to pass through.

A liquid crystal pattern 261 (G-CLC) whose operating waveband is a green light waveband covers a subpixel 231 (G) displaying green light. The liquid crystal pattern 261 (G-CLC) is configured to reflect, back to the light emitting layer 230, light emitted by the subpixel 231 in a second rotation direction (right-hand) in the green light, and allow light in a first rotation direction (left-hand) to pass through.

A liquid crystal pattern 261 (R-CLC) whose operating waveband is a red light waveband covers a subpixel 231 (R) displaying red light. The liquid crystal pattern 261 (R-CLC) is configured to reflect, back to the light emitting layer 230, light emitted by the subpixel 231 in a second rotation direction (right-hand) in the red light, and allow light in a first rotation direction (left-hand) to pass through.

Further, the cholesteric liquid crystal layer 260 further includes a protective layer covering the liquid crystal pattern 261. For related features of the protective layer, refer to the foregoing related descriptions, and details are not described herein again.

Optionally, in another implementation, operating wavebands of the plurality of liquid crystal patterns 251 may be the same, and all are visible light wavebands. Through the foregoing setting, processing and forming can be convenient, a production process can be simplified and the cost can be saved. In this case, at least a part of the plurality of liquid crystal patterns 251 may be connected to form an integral structure.

The display apparatus 200 in this embodiment of this application may be manufactured according to the following technological process:
1. Coat and align the cholesteric liquid crystal layer 260: The cholesteric liquid crystal layer 260 is regularly arranged to an orientated state by light alignment or liquid crystal self-assembly, and a thickness of the cholesteric liquid crystal layer 260 is between 2 and 5 microns. The operating waveband of the cholesteric liquid crystal is one of R/G/B.
2. Pattern the liquid crystal pattern 261: After liquid crystal molecules are oriented, the molecules are arranged based on the orientation. At this time, a mask (mask, also referred to as an optical mask template) is placed above a liquid film, and a light source that induces polymerization of the oriented molecules is placed above the mask. At this time, only a part of the film that is not shielded by the mask can be irradiated and polymerized, and a part of the film that is shielded by the mask is not polymerized. Unpolymerized monomer molecules can be removed by cleaning with a solvent, so that the patterned liquid crystal pattern 261 is formed. In this embodiment of this application, the liquid crystal pattern 261 that is not blocked by the mask, that is, the retained liquid crystal pattern 261 is located above the corresponding subpixel.
3. Repeat steps 1 and 2: Coating and patterning of the liquid crystal patterns 261 of the R/G/B wavebands are performed respectively as required, and a manufacturing process is the same as steps 1 and 2. Finally, any combination of three liquid crystal patterns 261 can be obtained.
4. Coat the protective layer: An OC material such as resin is applied as a protective and flattening layer on the panel on which the liquid crystal pattern 261 is produced.
5. Attach the circular polarizer 270 to the cover layer 290: The manufactured panel is attached to the circular polarizer 270 and the cover layer 290 (for example, a glass cover) in sequence.

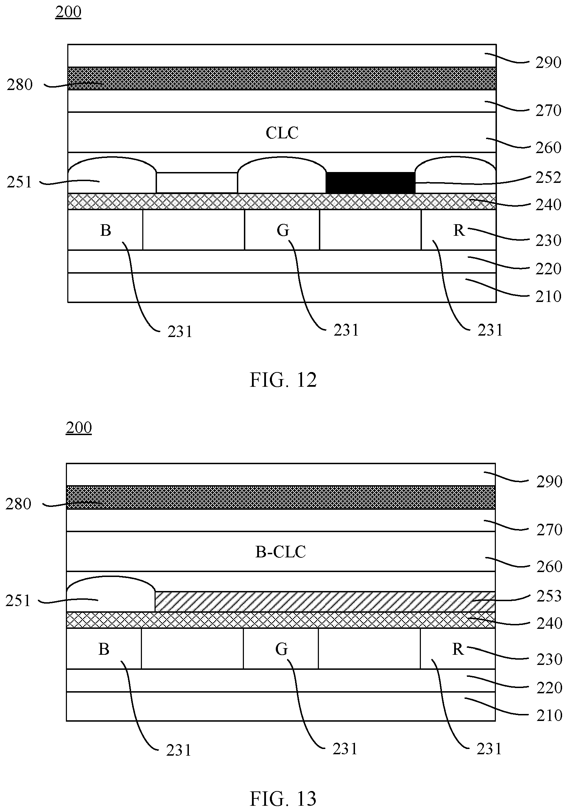

FIG. 12 is a schematic diagram of a structure of still another example of a display apparatus 200 according to an embodiment of this application. As shown in FIG. 12, in this embodiment of this application, a cholesteric liquid crystal layer 260 is in a thin-film-like integral structure, and an operating waveband of the cholesteric liquid crystal layer 260 is a visible light waveband (CLC). The foregoing setting helps save production processes and improve production efficiency.

Further, as shown in FIG. 12, the light converging layer 250 further includes a black matrix 252 surrounding the light converging structure 251. Through the foregoing setting, the black matrix 252 can absorb ambient light emitted from the external environment, to reduce the reflective index of the apparatus and improve the contrast percentage of the apparatus.

An OLED light source is a non-collimated light source. A light spot of the OLED light source increases significantly after two reflections occur at an interface between the cholesteric liquid crystal layer 260 and the light emitting layer 230. After being absorbed by the black matrix 252, light extraction gain is significantly affected. Therefore, the light converging structure 251 is provided to converge the light emitted by the OLED, which can effectively reduce the influence of the black matrix 252 on the gain. Alternatively, an area of the patterned cholesteric liquid crystal layer 260 (that is, the liquid crystal pattern 261) may be reduced, to reduce an increase in reflection of the ambient light.

FIG. 13 is a schematic diagram of a structure of still another example of a display apparatus 200 according to an embodiment of this application. As shown in FIG. 13, in this embodiment, the plurality of light converging structures 251 cover the plurality of blue subpixels 231 in a one-to-one correspondence, and an operating waveband of the cholesteric liquid crystal layer 260 includes a blue waveband. In other words, in this case, only output efficiency of light of the blue light is improved, which is beneficial to saving power consumption of the apparatus and facilitating processing.

Further, the light converging layer 250 further includes a yellow photoresist 253 surrounding the light converging structure 251. The yellow photoresist 253 allows green light and red light to pass through, and absorbs light of another waveband. By setting the yellow photoresist 253, the reflective index of the apparatus can be reduced and the contrast percentage of the apparatus can be improved.

The display apparatus 200 shown in FIG. 12 or FIG. 13 may be manufactured according to the following technological process:
1. Form the cholesteric liquid crystal layer 260: The cholesteric liquid crystal layer 260 may be made of a cholesteric liquid crystal and a substrate. An alignment layer is first coated on the substrate, and then the cholesteric liquid crystal layer with a thickness of 1 to 5 microns is coated. The alignment process adopts friction alignment or light alignment or liquid crystal self-assembly. The operating waveband of the cholesteric liquid crystal layer 260 for reflection includes a single waveband of R/G/B or any combination thereof, and may also include the entire visible light waveband.

The substrate may be a circular polarizer, a triacetyl cellulose (triacetyl cellulose, TAC), a cyclo olefin polymer (cyclo olefin polymer, COP), a glass (0.02 to 0.5 mm), a composite polymer film, or the like.

Alignment process: friction alignment: A base material is placed on a bearing platform, and a side of the coated alignment film is upward. The bearing platform is combined with a driving mechanism, and the driving mechanism drives the bearing platform to carry out linear transportation. A roller with a wool cloth attached to a surface is arranged on a base material conveying path. When the base material passes through the roller, the roller performs rolling friction on the alignment film on the surface of the substrate in a clockwise rolling manner in which a tangential speed direction of a bottom of the roller is opposite to a traveling direction of the base material. After friction alignment, molecules on the surface of the alignment film are not scattered, but are in a uniform arrangement, so that the liquid crystals can be arranged in a predetermined direction.

Light alignment: The light alignment belongs to non-contact alignment. A photosensitive polymer monomer material is chemically reacted to generate anisotropy by using ultraviolet light of a high precision real-time tracking compensation mode, and liquid crystal molecules interact with surface molecules of an alignment film to achieve a stable state of minimum energy. The liquid crystal molecules are arranged along a direction of maximum force defined by the light alignment.
2. Attach the circular polarizer 270 to the cholesteric liquid crystal layer 260. If the cholesteric liquid crystal layer 260 is not directly coated on the circular polarizer 270, the cholesteric liquid crystal layer 260 and a phase compensation film surface of the circular polarizer 270 need to be attached by using optically clear adhesive or pressure sensitive adhesive (pressure sensitive adhesive, PSA).
3. Black matrix 252 (also referred to as visible light absorption layer): If the cholesteric liquid crystal layer 260 operates on the entire visible light waveband, a black photoresist layer is prepared on an upper surface of a display screen as an absorption layer. First, a black photoresist is coated, and then the black matrix 252 is formed based on a yellow light process, and the absorption region corresponds to a non-light emitting region of the light emitting layer 230. If the cholesteric liquid crystal layer 260 operates on a single waveband of R/G/B, a complementary color photoresist may be coated as the absorption layer, and a coating region is the non-light emitting region of the light emitting layer 230.
4. Light converging structure: For the specific manufacturing process, refer to the related descriptions above.
5. Attach the circular polarizer 270 to the cover layer 290: The manufactured panel is attached to the circular polarizer 270 and the cover layer 290 (for example, a glass cover), where the cholesteric liquid crystal layer 260 is located between the display and the circular polarizer 270.

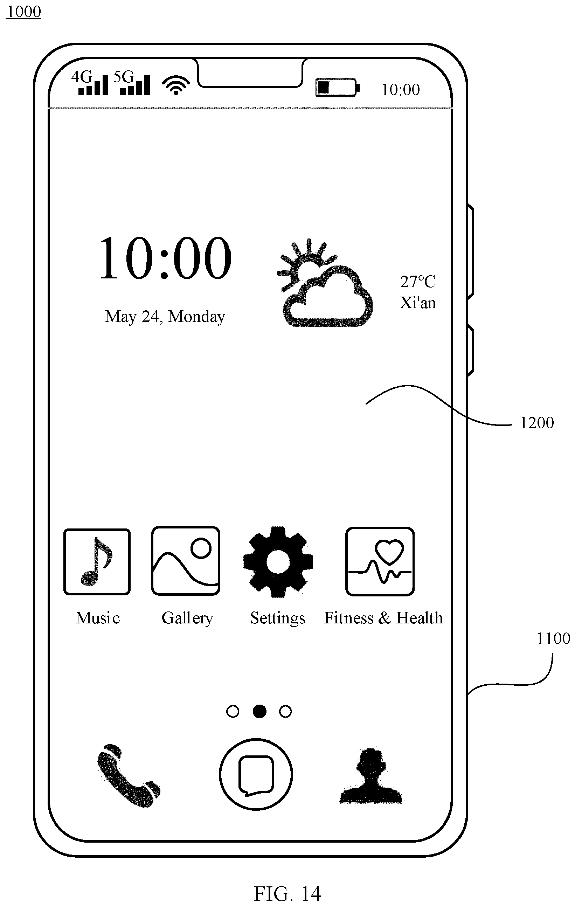

According to another aspect, an embodiment of this application further provides an electronic device. FIG. 14 is a schematic diagram of a structure of an electronic device 1000 according to an embodiment of this application. As shown in FIG. 14, the electronic device 1000 includes a housing 1100 and a display apparatus 1200. The display apparatus 1200 is installed on the housing 1100. The display apparatus 1200 is the display apparatus 100 or the display apparatus 200 according to any one of the foregoing embodiments.

Optionally, the electronic device 1000 is any electronic product with a display function, and includes but is not limited to a mobile phone (like a foldable mobile phone), a tablet computer, a television, a notebook computer, a computer display, a smart watch, an in-vehicle display device, a navigator, and the like.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A display apparatus, comprising:
a substrate;
a light emitting layer, disposed on the substrate, wherein the light emitting layer comprises a plurality of subpixels; and
a light converging layer, disposed on a side that is of the light emitting layer and that is away from the substrate, wherein the light converging layer comprises a plurality of light converging structures, the plurality of light converging structures cover the plurality of subpixels, and the light converging structures are configured to converge light emitted by the subpixels covered by the light converging structures.

2. The display apparatus according to claim 1, wherein the plurality of light converging structures cover the plurality of subpixels in a one-to-one correspondence.

3. The display apparatus according to claim 1 or 2, wherein the display apparatus further comprises:
a light filtering layer, disposed between the light emitting layer and the light converging layer, wherein the light filtering layer comprises a plurality of color resistance units and a black matrix surrounding the color resistance units, and the plurality of color resistance units cover the plurality of subpixels in a one-to-one correspondence.

4. The display apparatus according to claim 2, wherein a percentage of an area of the light converging structure to a light emitting area of the subpixel corresponding to the light converging structure is 0.6 to 2.2, and the area of the light converging structure is a cross-sectional area at a height of 10% of a total height of the light converging structure.

5. The display apparatus according to any one of claims 1 to 4, wherein the height of the light converging structure is greater than or equal to 2 microns.

6. The display apparatus according to any one of claims 1 to 5, wherein the display apparatus further comprises:
a protective layer, disposed on a side that is of the light converging layer and that is away from the substrate, wherein a refractive index of the light converging structure is greater than a refractive index of the protective layer.

7. The display apparatus according to claim 6, wherein a difference between the refractive index of the light converging structure and the refractive index of the protective layer is 0.1 to 0.5.

8. The display apparatus according to claim 6, wherein the display apparatus further comprises:
a scattering layer, disposed on the side that is of the light converging layer and that is away from the substrate, wherein a haze value of the scattering layer is 20% to 70%.

9. The display apparatus according to claim 8, wherein the scattering layer is formed by scattering particles dispersed inside the protective layer.

10. The display apparatus according to any one of claims 1 to 7, wherein the display apparatus further comprises:
an encapsulation layer, disposed between the light emitting layer and the light converging layer; and
a scattering layer, disposed between the encapsulation layer and the light converging layer, wherein a haze value of the scattering layer is 5% to 85%.

11. The display apparatus according to claim 10, wherein the display apparatus further comprises:
a touch layer, disposed between the encapsulation layer and the light converging layer, wherein the touch layer comprises an overcoating layer, and the scattering layer is formed by scattering particles dispersed inside the overcoating layer.

12. The display apparatus according to any one of claims 1 to 11, wherein the plurality of light converging structures cover a plurality of blue subpixels in a one-to-one correspondence.

13. The display apparatus according to any one of claims 1 to 12, wherein the subpixel comprises an organic light emitting diode or a micron light emitting diode.

14. The display apparatus according to any one of claims 1 to 13, wherein the light converging structure is a light converging microlens.

15. The display apparatus according to claim 9, wherein the scattering particle is in a spherical structure, and a diameter of the spherical structure is 1 to 3 microns.

16. The display apparatus according to claim 1 or 2, wherein the display apparatus further comprises:
a cholesteric liquid crystal layer, disposed on the side that is of the light emitting layer and that is away from the substrate, wherein the cholesteric liquid crystal layer is configured to reflect, to the light emitting layer, light emitted by the subpixel in a second rotation direction, and allow light in a first rotation direction to pass through, and the light emitting layer is further configured to rotate the light in the second rotation direction to the first rotation direction and reflect the light to the cholesteric liquid crystal layer; and
a circular polarizer layer, disposed on a side that is of the cholesteric liquid crystal layer and that is away from the substrate, wherein the circular polarizer layer comprises a retardation film and a linear polarizer, and the phase retardation film is configured to convert the light in the first rotation direction into vertical polarized light or horizontal polarized light that can pass through the linear polarizer.

17. The display apparatus according to claim 16, wherein the cholesteric liquid crystal layer comprises a plurality of liquid crystal patterns, and the plurality of cholesteric liquid crystal patterns cover the plurality of subpixels in a one-to-one correspondence.

18. The display apparatus according to claim 16 or 17, wherein an operating waveband of the cholesteric liquid crystal layer comprises entire visible light.

19. The display apparatus according to any one of claims 16 to 18, wherein the light converging layer further comprises a black matrix surrounding the light converging structure.

20. The display apparatus according to claim 16 or 17, wherein the plurality of light converging structures cover a plurality of blue subpixels in a one-to-one correspondence, and the operating waveband of the cholesteric liquid crystal layer comprises a blue light waveband.

21. The display apparatus according to claim 20, wherein the light converging layer further comprises a yellow photoresist surrounding the light converging structure.

22. An electronic device, comprising a housing and the display apparatus according to any one of claims 1 to 21, wherein the display apparatus is mounted on the housing.
